# EUROPEAN PATENT APPLICATION

(11) **EP 4 404 701 A1**
(43) Date of publication of application: **24.07.2024**
(21) Application number: 23220482.6
(22) Date of filing: 28.12.2023
(51) Int. Cl.: H05K 7/14

(54) **INVERTER UNIT FOR ELECTROMECHANICAL PUMPS**

(30) Priority: 16.01.2023 IT 202300000498
(71) Applicant: Dab Pumps S.p.A., 35035 Mestrino (Padova) (IT)
(72) Inventor: TAZIOLI, Stefano, 35035 MESTRINO (PD) (IT); SPORTOLETTI, Sergio, 35035 MESTRINO (PD) (IT)
(74) Representative: De Filippis, Sara

(57) **Abstract**

The invention relates to an inverter unit (100) for an electromechanical pump, comprising: a first half-shell (40) having a base (41), a second half-shell (30) having a body (31), an inverter (101), for the conversion of electric current, housed between the first half-shell (40) and the second half-shell (30).

The second half-shell (30) comprises one or more guide pins (3) fixed along the perimeter of the body (31); said first half-shell (40) has one or more engagement/disengagement holes (33) obtained on the base (41), and the guide pins (3) of the second half-shell (30) are arranged to each engage a corresponding engagement/disengagement hole (33) when the second half-shell (30) is closed on the first half-shell (40).

## Description

The present invention relates to an inverter unit for electromechanical pumps.

### Field of the invention

The invention fits in the technical field of electromechanical pumps, in particular in the technical field of accessories and components for electromechanical pumps and the like.

### Prior art

Nowadays, the market has a wide range of inverters used in many different fields of application.

Inverters are used to power accumulators, systems, air conditioners, electric motors for motor cars, electromechanical devices, uninterruptible power supplies, etc. In particular, an inverter can be installed in all those situations in which a conversion from direct current to alternating current is necessary.

In addition, the term inverter can also be understood as a "rectifier-inverter" assembly, powered by alternating current, used to vary the voltage and the frequency of the alternating current output as a function of the current input, for example for the power supply of particular operating machines.

With regard to the technical field of electromechanical pumps, solutions are described in the prior art in which the characteristic elements of an inverter are integrated and comprised within a pump body, i.e. a containment casing, of the electromechanical pump itself.

Alternatively, with particular reference to some types of electromechanical pumps and electric pumps, the inverter can be mounted externally to the pump body, but generally in contact with the pump itself.

The solutions described above and present today on the market have several disadvantages due to the positioning and construction of the inverters applied to the technical field of electromechanical pumps.

A first disadvantage of the aforementioned solutions is related to the difficulty of carrying out maintenance operations on an inverter connected to a pump already installed in a system and which, as often happens, is located in a position that is not easily accessible to a user or maintenance technician.

In fact, in order to carry out such maintenance operations, it is often necessary to completely disassemble the inverter and/or pump body of the electromechanical pump. This disassembly operation involves long processing times and also risks for the maintenance technicians who work in contact with the electrical components of the inverter.

In addition, as is well known, the inverter comprises very delicate electrical and electronic elements, such that maintenance operations can turn out to be difficult, especially if carried out in uncomfortable and inaccessible areas.

These limits are also linked to the positioning of a display with which the electromechanical pumps are usually equipped, which in some cases can be difficult to read, e.g. if oriented towards walls or areas that are not easily accessible.

### Object of the invention

An object of the present invention is therefore to provide an inverter unit for electromechanical pumps capable of solving the above-mentioned drawbacks and criticalities.

It is also an object of the present invention to realize an inverter unit for electromechanical pumps that facilitates maintenance and assembly/disassembly of the inverter.

Another object of the present invention is to provide an inverter unit for electromechanical pumps that can be installed in an area other than the location of the electromechanical pump.

Another object of the present invention is to realize an inverter unit for electromechanical pumps that can be installed on a wall or on a panel.

### Object of the invention

It is therefore a specific object of the present invention an inverter unit for an electromechanical pump, comprising: a first half-shell having a base, a second half-shell having a body, an inverter, for the conversion of electric current, housed between said first half-shell and said second half-shell, wherein the second half-shell comprises one or more guide pins fixed around the perimeter of said body, the first half-shell has one or more engagement/disengagement holes formed on the base and the guide pins of the second half-shell are arranged to engage each a corresponding engagement/disengagement hole when the second half-shell is closed on the first half-shell.

Again according to the invention, the guide pins are made with a symmetrical geometry with respect to a vertical axis perpendicular to the longitudinal centreline plane and passing through the centre of said guide pins.

Preferably, the guide pins comprise: a cylindrical central portion, two conical intermediate portions suitable to ensure the mechanical coupling, according to the Morse cone principle, of said guide pins with one or more coupling holes present in the body and two end portions, having a cross-sectional area with greater conicity than the cross-sectional area of the intermediate portions, to favor the insertion of the guide pins into the engagement/disengagement holes during the closing of the inverter unit.

Still according to the invention, the inverter unit comprises one or more band springs fixed near the perimeter of the body and interposed between said first half-shell and said second half-shell, so as to exert a force in the direction of the first half-shell and facilitate decoupling the first half-shell from said second half-shell.

Advantageously according to the invention, one or more containment holes are cut along the perimeter of the base and one or more helical springs inserted into said containment holes so as to exert a force in the direction of the second half-shell to facilitate the decoupling of the second half-shell from the first half-shell.

Further according to the invention, the helical springs comprise: a fixed end having a number of coils sufficient to hold the helical springs within the respective containment holes and a free end comprising a thrust pad to enlarge the contact surface between the helical spring and the second half-shell in order to transmit the force exerted by the helical spring on the second half-shell.

Still according to the invention, the containment holes have an internal thread and the last coil of said fixed end is bent to facilitate the insertion of the helical springs into the containment holes and to screw the helical springs to the thread of the containment holes.

Still according to the invention, the second half-shell comprises one or more handles for disengaging the second half-shell from the first half-shell and opening the inverter unit.

Advantageously according to the invention, recesses are present on at least one pair of opposite sides of the first half-shell and/or the second half-shell for engaging a pair of opening keys so that, by simultaneously applying a pair of forces on the side portions of each opening key, a lever is generated on the half-shells that facilitates the disengagement of the second half-shell from the first half-shell and favors the opening of the inverter unit.

Preferably according to the invention, the first half-shell and the second half-shell comprise one or more thrust planes for applying a first force on the first half-shell and a second force on the second half-shell and the first force is applied in the opposite direction with respect to the second force.

Furthermore according to the invention, the thrust planes are knurled to indicate the correct zone of application of the first and second forces and increase the adherence of said thrust planes (54).

These and other objects are achieved by an inverter unit for electromechanical pumps according to the accompanying independent claim.

Further detailed technical features are set out in the appended dependent claims.

### Brief description of the figures

The present invention will now be described by way of non-limiting example according to some preferred embodiments thereof, and with the aid of the appended figures, in which:
figure 1 is an isometric view of an aeroponics container according to the invention;
figure 2 illustrates the two half-shells of the inverter unit for electromechanical pumps of figure 1;
figure 3 illustrates, in a further view, the two half-shells of the inverter unit for electromechanical pumps of figure 1;
figure 4 is a perspective view of the first half-shell and the anchoring plate of the inverter unit for electromechanical pumps, according to the invention;
figure 5 is a perspective view of the first half-shell of the inverter unit for electromechanical pumps, according to the invention;
figure 6 is an exploded view of the first half-shell of the inverter for electromechanical pumps, according to the invention;
figure 7 is a perspective view of the first half-shell without any connected components, according to the invention;
figure 8 is an exploded view of the second half-shell of the inverter unit for electromechanical pumps, according to the invention;
figure 9 is a side view of an embodiment of a guide pin, according to the invention;
figures 10A-10C are sectional views of the inverter unit, illustrating the coupling of the two half-shells by means of the guide pins;
figure 11 illustrates an embodiment of the present invention in which band springs are present to facilitate opening of the inverter unit;
figures 12A-11D illustrate an embodiment of the present invention in which helical springs are present to facilitate opening of the inverter unit;
figures 13A-13C illustrate the opening of the inverter unit by using the opening keys, according to the invention; and
figures 14A-14B show inverter units in which the thrust planes for facilitating opening are present, according to the invention.

### Detailed description

In the various figures, similar parts will be indicated with the same numerical references.

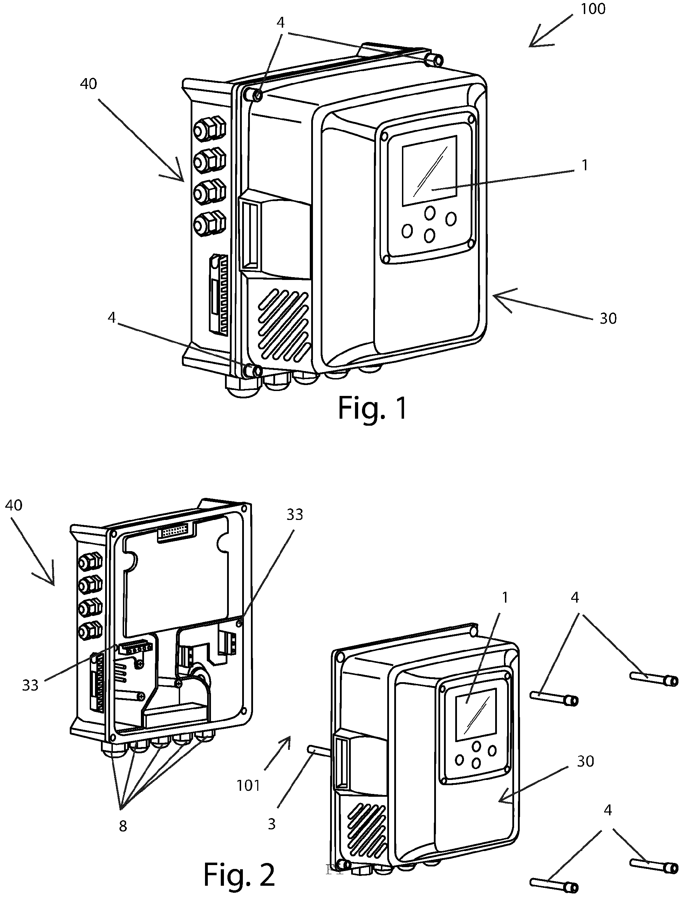

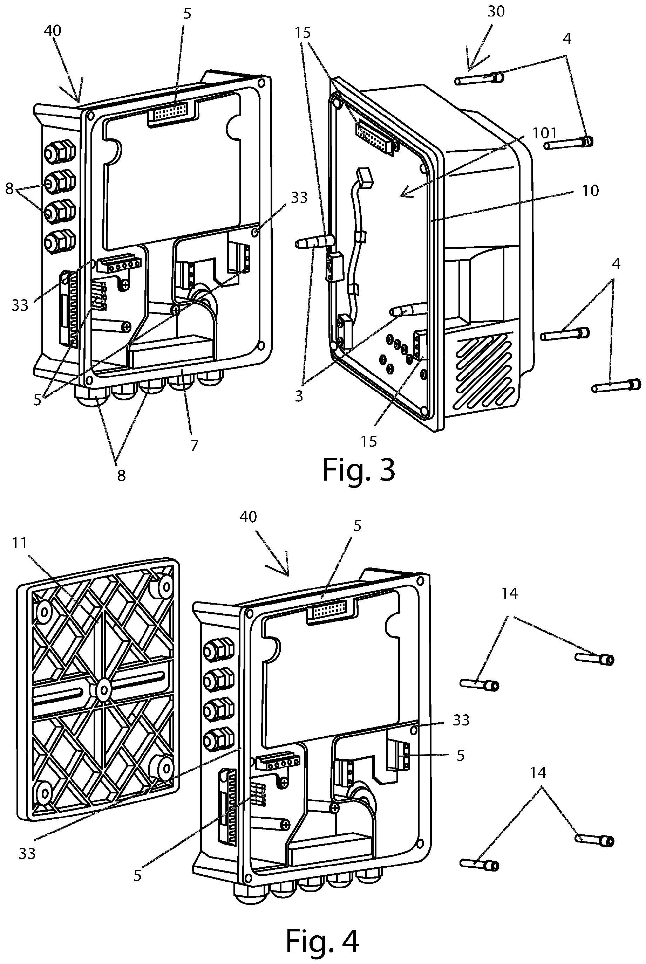

With reference to figures 1-8, a first embodiment of an inverter unit for electromechanical pumps according to the invention can be observed.

The inverter unit for electromechanical pumps subject-matter of the invention is indicated with the reference numeral 100 and, in said first embodiment, according to the present invention, it comprises an inverter 101, a first half-shell 40, also called "DOCK", and a second half-shell 30, called "DRIVER".

The first half-shell 40 is fixable, for example, to a wall, to a support element or to the pump body of an electromechanical pump.

In the embodiment shown the first half-shell 40 houses all the electrical and mechanical connections of the inverter 101. In addition, the first half-shell 40 comprises a base 41, which in the case under examination is made of aluminium, but it can also be made of other materials, in which one or more holes are made into which one or more plugs and/or cable glands 8 are insertable that allow the passage of cables inside the first half-shell 40.

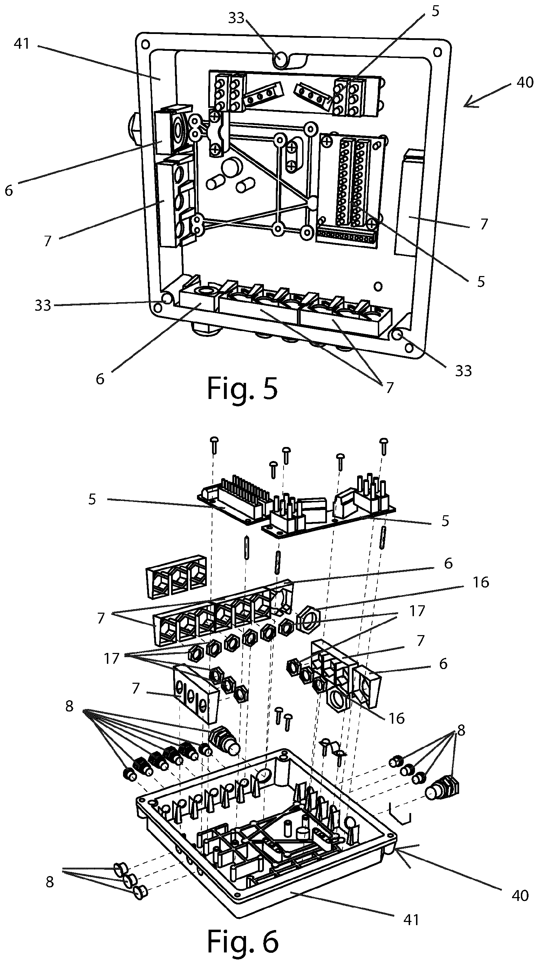

The base 41 (with reference in particular to Figure 5) is arranged for direct fixing on an electromechanical pump or any other element, for example by means of blind holes to be used as required.

The base 41 comprises guides 26 for housing one or more signal ferrule holders 7 and/or one or more input/output ferrule holders 6. Each hole of the base 41 is placed at a signal ferrule holder 7 or at an input/output ferrule holder 6. In particular, each signal ferrule holder 7 or input/output ferrule holder 6 is arranged to house therein respectively a signal ferrule 17 or an input/output ferrule 16.

The ferrule holders 6, 7 with the ferrules 16 and 17 altogether allows the effective insertion and fixing of the plugs and/or cable glands 8 and the cables that pass through them. In particular, by inserting the plugs and/or cable glands 8 into the holes placed at the ferrule holders 6, 7 and the ferrules 16, 17, it is possible to fix the plugs and/or cable glands 8 to the base 41 of the first module 40.

The base 41 houses one or more connectors 5 for connection with the motherboard 10. By way of example, the connectors 5 may be linear coupling connectors. In other embodiments, different connectors may be provided.

These connectors 5 are fixed to the first half-shell 40 by means of suitable fixing means, such as screws or rivets, which are inserted into special holes present on the base 41 of the first half-shell 40.

The connectors 5 allow the connection of corresponding attachments 15 present on the motherboard 10.

The second half-shell 30 houses the inverter 101 and all its electrical and/or electronic components including, for example, the motherboard 10.

In particular, the second half-shell 30 contains the electrical components which are generally more delicate than the inverter 101, which may therefore require more maintenance or replacement.

The second half-shell 30 comprises a body 31, by way of example in aluminium, for housing the components of the inverter 101 that need ordinary or special replacement and maintenance.

The body 31 is designed to house the motherboard 10, fixed to the same body 31 of the second half-shell 30 by means of further fixing means.

The motherboard 10 comprises all the main electrical and electronic components for the correct operation of the inverter 101. The motherboard 10 comprises inter alia the attachments 15 for connection to the respective connectors 5 present in the first half-shell 40.

The second half-shell 30 also comprises an HMI unit or display 1 for receiving, displaying and transmitting signals or commands by the users of the inverter unit 100. In the embodiment under examination, the HMI unit or display 1 may comprise a screen and a push-button panel or exclusively a touch screen type screen.

The first half-shell 40 and the second half-shell 30 are fixed to each other through a plurality of fixing means 4. Said fixing means 4 may be screws or rivets.

To favor and guide the engagement and the disengagement of the second half-shell 30 from the first half-shell 40, the second half-shell 30 provides one or more guide pins 3.

The guide pins 3 are inserted and fixed along the perimeter of the body 31 which is comprised in the second half-shell 30. In this way, the engagement and the disengagement of the second half-shell 30 takes place easily and quickly, allowing the replacement and/or maintenance operations of the inverter 101 and the components thereof to be carried out more easily and conveniently.

In particular, the guide pins 3, when inserted in the corresponding engagement/disengagement holes 33, allow the weight of the second half-shell 30 to be supported pending fixing to the first half-shell 40 and allow the attachments 15 present in the motherboard 10 to be directed in the direction of the corresponding connectors 5 of the first half-shell 40.

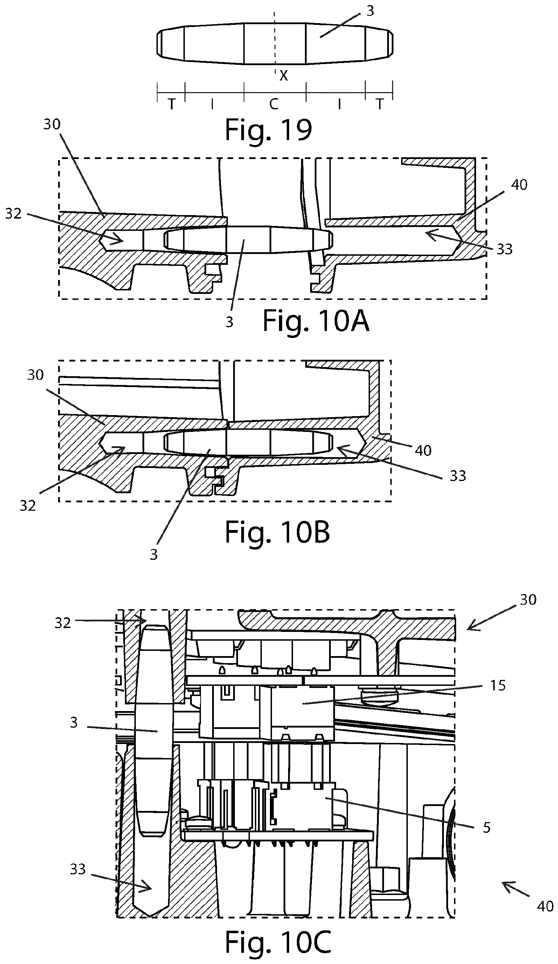

Referring to figures 9, 10A, 10B and 10C, an embodiment of the guide pins 3 and of the relative coupling with the half-shells 30 and 40 is shown.

These guide pins 3 are arranged to be inserted into corresponding engagement/disengagement holes 33 present in the first half-shell 40.

In particular, referring to figure 9, each guide pin 3 is made with a symmetrical geometry with respect to a vertical axis X perpendicular to the longitudinal centreline plane and passing through the centre of the pins 3 themselves. More specifically, each guide pin 3 comprises:
- a central cylindrical portion C, with a calibrated diameter, which while closing the inverter unit 100 allows, by fitting into the corresponding engagement/disengagement hole 33, to ensure the precise positioning of the two half-shells 30, 40;
- two conical intermediate portions I, with cross-sectional area having conicity included in the range of Morse angles, designed so as to ensure the mechanical coupling of the guide pins 3 with the second half-shell 30;
two end portions T, having a cross-sectional area with greater conicity than the cross-sectional area of the intermediate portions I, suitable for favouring the insertion of the guide pins 3 into the corresponding engagement/disengagement holes 33 during the closing of the inverter unit 100.

In this embodiment, the guide pins 3 are mechanically coupled to coupling holes 32 present along the perimeter of the body 31.

The insertion and the fixing of the guide pins 3 in the coupling holes 32 are favored by the specific shape of the pins 3 themselves, which guarantees coupling according to the Morse cone principle.

With reference now to figures 10A-10C, the guide pin 3 is shown both during the closing step of the inverter unit 100, and as it is coupled to the second half-shell 40.

In the figures it can be seen that a portion of the guide pin 3 is stably coupled to the coupling hole 32. This coupling operation is carried out by the operator only once. Instead, the other portion of the guide pin 3 is insertable into and disengageable from the engagement/disengagement hole 33, should the second half-shell 40 be removed for maintenance.

In other words, in this step, the cylindrical portion C of the guide pin 3 is already partially engaged in the engagement/disengagement hole 33 of the first half-shell 40, while a gap is still present between the connectors 5 and the corresponding attachments 15.

Advantageously, the guide pins 3 allow the precise and facing positioning of the two half-shells 30, 40 before the attachments 15 can be connected to the connectors 5, ensuring a linear coupling without any tensioning to the same attachments 15.

In other words, the second half-shell 30 engages to and disengages from the first half-shell 40 by means of electrical elements, i.e. by means of the connectors 5, and mechanical elements, i.e. by means of the guide pins 3.

In further embodiments, one or more of the solutions described below may be used to facilitate disengagement of the second half-shell 30 from the first half-shell 40. Such solutions may comprise:
- the use of one or more band springs 50;
- the use of one or more helical springs 51;
- the use of handles 52;
- the use of one or more pairs of opening keys 53;
- the use of thrust planes 54.

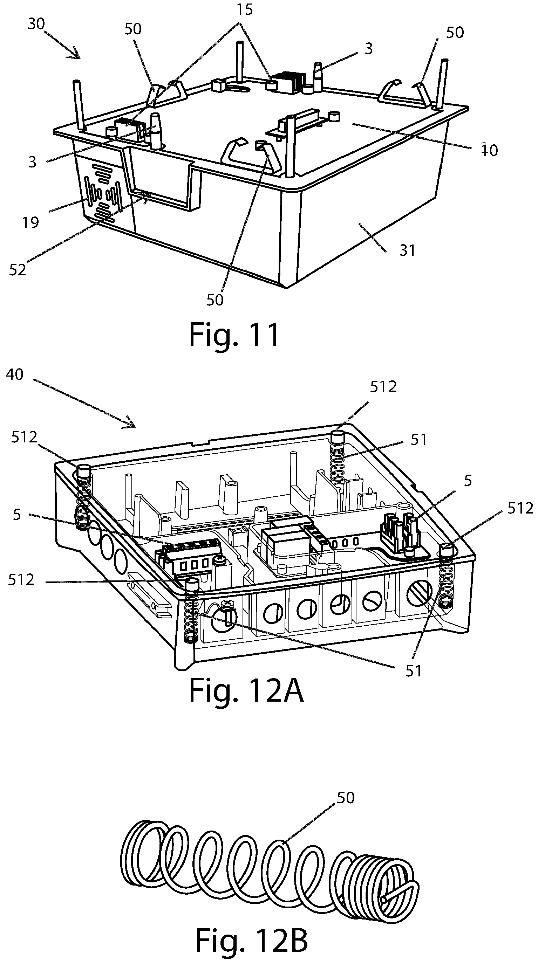

Referring to figure 11, three band springs 50 can be seen attached near the perimeter of the body 31 of the second half-shell 30.

The band springs 50 exert a force in the direction of the first half-shell 40, so as to facilitate the separation of the second half-shell 30 from the first half-shell 40 and the partial disengagement of the attachments 15 from the connectors 5.

In the opening step, since the attachments 15 are at least partially disengaged from the connectors 5, it is possible to reduce the force necessary to disengage the second half-shell 30 from the first half-shell 40.

With reference to figures 12A-12D, helical springs 51 are inserted into special containment holes 511, made along the perimeter of the base 41 of the first half-shell 40.

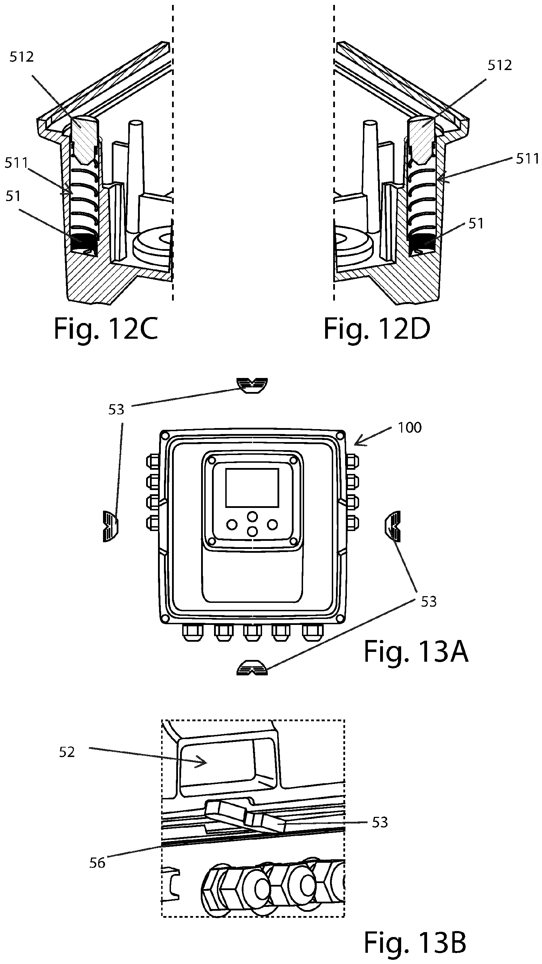

The helical springs 51 vary their extension from a compressed configuration, when the inverter unit 100 is closed, visible in figure 12D, to an extended configuration, when the inverter unit 100 is open, visible in figure 12C. The force exerted by the helical springs 51, in the passage from the compressed configuration to the extended configuration, facilitates the disengagement of the second half-shell 30 from the first half-shell 40. The helical springs 51 have a fixed end, intended for coupling in the corresponding containment hole 511, and a free end able to move inside the same containment hole 511. The fixed end of the helical springs 51 comprises a number of coils sufficient to hold, due to the friction generated, the same helical springs 51 inside the corresponding containment holes 511.

In addition, the last coil of the helical springs 51 can be bent so as to facilitate the insertion of the same helical springs 51 within the containment holes 511 and possibly screw them to a possible thread, not visible in the figures, present inside the containment hole 511.

The free end of the helical springs 51 comprises a thrust pad 512. This thrust pad 512 is placed in contact with the second half-shell 30 when the inverter unit 100 is closed.

The thrust pad 512 is able to enlarge the contact surface between the spring and the second half-shell 30 and more effectively transmit the force exerted by the same helical spring 51. In this way, a greater force is generated that facilitates the disengagement of the second half-shell 30 from the first half-shell 40.

In a further embodiment, the second half-shell 30 may comprise one or more handles 52, visible in Figure 11, to favor manual gripping, by a user, of the same half-shell 30 and facilitate disengagement from the first half-shell 40 by the application of a manual force.

Referring to figures 13A-13C, a further embodiment of the inverter unit 100 according to the invention can be observed, in which the use of one or more pairs of opening keys 53 is provided, which are to be inserted into special recesses 56 present on opposite sides of the first half-shell 40 and/or the second half-shell 30.

In particular, the recesses 56 are made along the perimeter of the half-shells 30 and 40. Further, the recesses 56 may be made on both the half-shells 30 and 40. In this case, the recesses 56 are arranged so that, when the inverter unit 100 is closed, the recesses 56 in the first half-shell 40 are aligned with the corresponding recesses 56 in the second half-shell 30.

In this embodiment, it is necessary to insert a pair of keys 53 into the respective recesses 56 and simultaneously rotate the same keys 53 by applying, with the thumb and the index finger, a pair of forces on the side portions of each opening key 53. In this way a lever sufficient to overcome the disengagement resistance of the two half-shells 30 and 40 and to allow a smoother opening of the inverter unit 100 is generated.

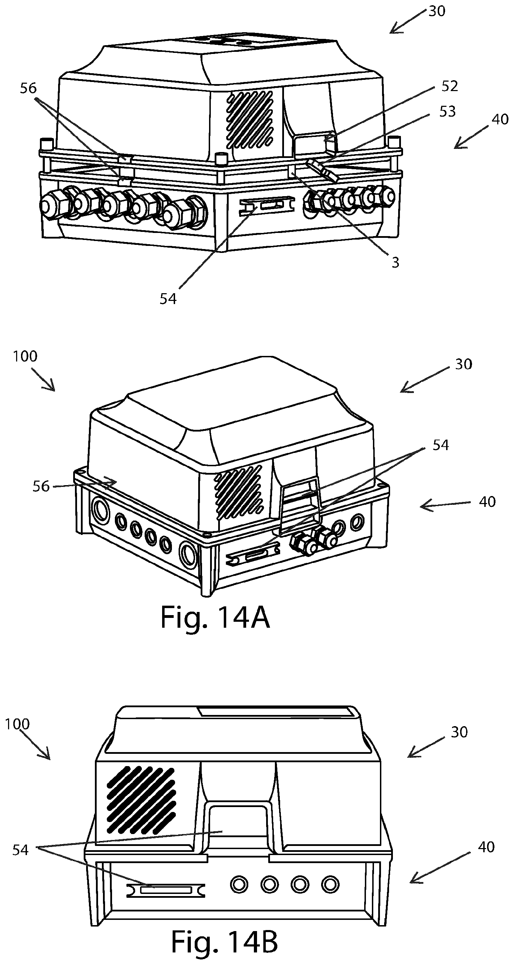

With reference to figures 14A and 14B, on the half-shells 30 and 40 there are thrust planes 54 made so as to provide areas in which the fingers of a user can be positioned and impart a force useful for the disengagement of the two half-shells 30, 40. In particular, the thrust planes 54 are made on the two half-shells 30 and 40 in such a way as to carry out a simultaneous thrust, in the opposite direction, on the first half-shell 30 and on the second half-shell 40, thus facilitating the opening of the inverter unit 100.

In a further embodiment, the thrust planes 54 are knurled, so as to allow a user to visually guess which is the correct area of application of the force and to increase the adherence of the thrust planes 54 themselves.

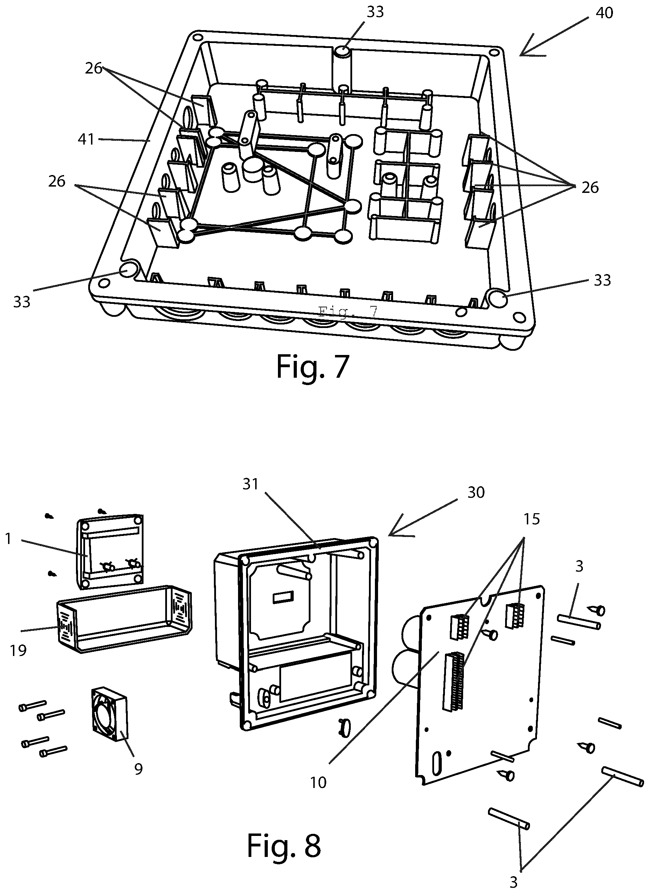

Referring to Fig. 8, a cooling fan 9 is connected to the second half-shell 30 to avoid overheating problems of the electronic components of the inverter 101 internal to the second half-shell 30.

Furthermore, in order to prevent the cooling fan 9 from getting dirty or coming into contact with dust or dirt that might compromise its operation, the cooling fan 9 itself is housed inside a cover hull 19.

More specifically, in the embodiment shown in Figure 8, the cover hull 19 is connected to the second half-shell 30 by interlocking.
Advantageously, the cover hull 19 has holes or grilles to allow an effective air exchange between the inside and the outside of the same cover hull 19.

The cover hull 19 does not allow users of the electromechanical pump connected to the inverter unit 100 to come into contact with the cooling fan 9 so as to avoid injury to the users themselves and damages to the cooling fan 9 itself.

To fix the inverter unit 100 to a wall, a panel or any supporting device, an anchoring plate 11 is connected to the base 41 of the first half-shell 40.

In particular, the anchoring plate 11 comprises one or more holes for fixing or hooking to a wall, a panel, a pump or any other element or device.

In a further embodiment, the inverter unit 100 comprises a sealing element, not shown in the figures, interposed between the first half-shell 40 and the second half-shell 30 and adapted to maintain the seal of the inverter unit 100 itself. By way of example, the sealing element is a gasket or an O-Ring.

Operationally, the assembly operations of the inverter unit 100 are as follows:
- installation and fixing of the first half-shell 40 to a wall or a pump body;
- insertion of the power supply cables and electrical connections in the respective plugs and/or cable glands 8;
- wiring of the cables internally to the first half-shell 40;
- fixing of the signal ferrules 7 and the input/output ferrules 6;
- attachment of the second half-shell 30 to the first half-shell 40;
- fixing of the second half-shell 30 to the first half-shell 40 with the fixing means 4.

By means of the inverter unit 100 it is possible to perform replacement or maintenance operations of the electrical and electronic components of the inverter 100 internal to the second half-shell 30, without having to uninstall the entire inverter unit 100.

In particular, it is possible to remove only the second half-shell 30 without necessarily having to remove and subsequently reconnect and wire the electrical cables connected to the first half-shell 40.

Advantageously, the inverter unit 100 is designed to be connected to electromechanical pumps of new construction or already on the market, so that the inverter unit 100 can be sold as an element included in a pump or subsequently as an accessory.

The characteristics of the inverter unit for electromechanical pumps, subject-matter of the invention, are clear from the description made, as well as the advantages are clear.

It is clear, finally, that numerous other variants can be made to the device in question, without thereby departing from the principles of novelty inherent in the inventive idea, as well as it is clear that, in the practical implementation of the invention, the materials, shapes and dimensions of the details illustrated may be any according to the needs and they may be replaced with other equivalents.

Where the features and techniques mentioned in any claim are followed by reference indications, such reference indications have been included for the sole purpose of increasing the intelligibility of the claims and, accordingly, such reference indications have no limiting effect on the interpretation of each element identified by way of example by such reference indications.

## Claims

1. Inverter unit (100) for an electromechanical pump, comprising:
a first half-shell (40) having a base (41);
a second half-shell (30) having a body (31);
an inverter (101), for the conversion of electric current, housed between said first half-shell (40) and said second half-shell (30);
**characterized**
**in that** said second half-shell (30) comprises one or more guide pins (3) fixed around the perimeter of said body (31),
**in that** said first half-shell (40) has one or more engagement/disengagement holes (33) formed on said base (41), and
**in that** said guide pins (3) of said second half-shell (30) are arranged to engage each to a corresponding engagement/disengagement hole (33) when said second half-shell (30) is closed on said first half-shell (40).

2. Inverter unit (100) according to claim 1, **characterized in that** said guide pins (3) are realized with a symmetrical geometry with respect to a vertical axis (X) perpendicular to the longitudinal centreline plane and passing through the centre of said guide pins (3).

3. Inverter unit (100) according to the preceding claim, **characterized in that** said guide pins (3) comprise:
a central cylindrical portion (C);
two conical intermediate portions (I) suitable to ensure the mechanical coupling, according to the Morse cone principle, of said guide pins (3) with one or more coupling holes (32) present in said body (31);
two end portions (T), having a cross-sectional area of taper greater than the cross-sectional area of said intermediate portions (I), to facilitate the insertion of said guide pins (3) into said engagement/disengagement holes (33) during the closing of said inverter unit (100).

4. Inverter unit (100) according to one of the preceding claims, **characterized in that** said inverter unit (100) comprises one or more band springs (50) fixed near the perimeter of said body (31), said band springs (50) are interposed between said first half-shell (40) and said second half-shell (30), so as to exert a force in the direction of said first half-shell (40) and to facilitate decoupling said first half-shell (30) from said second half-shell (40).

5. Inverter unit (100) according to one of the preceding claims, **characterized in**
**that** one or more containment holes (511) are cut along the perimeter of said base (41), and
in comprising one or more helical springs (51) inserted into said containment holes (511) so as to exert a force in the direction of said second half-shell (30) in order to facilitate the decoupling of said second half-shell (30) from said first half-shell (40).

6. Inverter unit (100) according to the preceding claim, **characterized in that** said helical springs (51) comprise:
a fixed end having a number of coils sufficient to hold said helical springs (51) within said respective containment holes (511);
a free end comprising a thrust pad (512) to enlarge the contact surface between said helical spring (51) and said second half-shell (30) in order to transmit the force exerted by said helical spring (51) on said second half-shell (30).

7. Inverter unit (100) according to claim 6, **characterized**
**in that** said containment holes (511) have an internal thread, and
**in that** the last coil of said fixed end is bent to facilitate the insertion of said helical springs (51) into said containment holes (511) and to screw said helical springs (51) to said thread of said containment holes (511).

8. Inverter unit (100) according to one of the preceding claims, **characterized in that** said second half-shell (30) comprises one or more handles (52) for disengaging said second half-shell (30) from said first half-shell (40) and opening said inverter unit (100).

9. Inverter unit (100) according to one of the preceding claims, **characterized in that** recesses (56) are present on at least one pair of opposite sides of said first half-shell (40) and/or said second half-shell (30) for engaging a pair of opening keys (53) so that, by simultaneously applying a pair of forces on the side portions of each opening key (53), a lever is generated on said half-shells (30, 40) that facilitates the disengagement of said second half-shell (30) from said first half-shell (40) and favors the opening of said inverter unit (100).

10. Inverter unit (100) according to one of the preceding claims, **characterized**
**in that** said first half-shell (40) and said second half-shell (30) comprise one or more thrust planes (54) for applying a first force on said first half-shell (40) and a second force, on said second half-shell (30), and
**in that** said first force is applied in the opposite direction to said second force.

11. Inverter unit (100) according to the preceding claim, **characterized in that** said one or more thrust planes (54) are knurled to indicate the correct zone of application of said first and said second force and increase the adherence of said thrust planes (54).
